(19) **Europäisches Patentamt / European Patent Office / Office européen des brevets**

(11) **EP 2 295 997 B1**

(12) **EUROPEAN PATENT SPECIFICATION**

(45) Date of publication and mention of the grant of the patent:
**14.11.2018 Bulletin 2018/46**

(21) Application number: **09769379.0**

(22) Date of filing: **10.06.2009**

(51) Int Cl.:
***G01R 31/36*** (2006.01)

(86) International application number:
**PCT/ES2009/070218**

(87) International publication number:
**WO 2009/156533 (30.12.2009 Gazette 2009/53)**

(54) **METHOD FOR DIAGNOSING BATTERIES**

VERFAHREN ZUR DIAGNOSE VON BATTERIEN

PROCÉDÉ DE DIAGNOSTIC DE BATTERIES

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **10.06.2008 ES 200801752**

(43) Date of publication of application:
**16.03.2011 Bulletin 2011/11**

(73) Proprietor: **Metro de Madrid, S.A.**
**28007 Madrid (ES)**

(72) Inventors:
- **GONZALEZ FERNANDEZ, Francisco, Javier**
  **E-28007 Madrid (ES)**
- **GARCIA SAN ANDRES, Mª Antonia**
  **E-28007 Madrid (ES)**

- **SANCHO DE MINGO, Carlos**
  **E-28007 Madrid (ES)**
- **MUÑOZ CONDES, Pilar**
  **E-28007 Madrid (ES)**
- **GOMEZ PARRA, Miguel**
  **E-28007 Madrid (ES)**

(74) Representative: **Carpintero Lopez, Francisco et al Herrero & Asociados, S.L.**
**Cedaceros 1**
**28014 Madrid (ES)**

(56) References cited:
**EP-A1- 1 650 575      ES-B1- 2 178 954**
**ES-B1- 2 247 896      ES-T3- 2 236 580**
**JP-A- 2004 301 595    JP-A- 2005 091 217**
**JP-A- 2006 292 565    US-A1- 2007 001 679**
**US-A1- 2008 091 362**

**Description**

Object of the Invention

The object of the present application for an invention patent is the development of a method for diagnosing batteries in dynamic environments which allows assuring high battery reliability for implementing a predictive maintenance plan, anticipating the malfunction thereof.

More specifically, the method of the present invention is based on the measurement of the impedance of groups of cells or modules of the batteries to reduce the time used in performing the maintenance but without a loss of safety and reliability, and in which the effect of the temperature is furthermore taken into account.

Background of the Invention

The use of batteries is widespread today, and they are used in a number of applications and sectors of the art in which it is necessary to assure the operation of critical electrical equipment, such as, for example, industrial power generation facilities, sub-stations for protecting and controlling disconnectors and relays, telephone systems, emergency services, industrial applications for protection and control, computer or computer systems support, etc.

All these fields related to the use of batteries in perfectly controlled static environments in which the variations of the surrounding conditions are minimal.

However, there are fields in which the working conditions and the drawbacks associated with said conditions substantially differ from a stationary application, as occurs, for example, in the railway environment, in which the batteries are used to supply the minimum service power necessary in the event of malfunction of the operation of the main power supply equipment.

Even though batteries especially designed for railway applications are known today, no methodologies for maintaining said batteries are known which take into account the particular environment of railway work, so the maintenance thereof is performed in the same way as for those batteries installed in more structured environments in stationary or static conditions.

However, in the railway environment there are a series of very particular conditioning factors making battery maintenance, based on that which is used in stationary environments, not be the most suitable in terms of reliability, safety, or cost from the point of view of the time used to perform said maintenance.

Therefore, said particular conditions to be taken into account in railway environments differing from those of static environments could be summarized in three essential conditions:

- There is a variety of equipment. Railway operation has a very extensive convoy of mobile material having a very different typology, which means that the number of batteries to be maintained in optimal conditions is very high. This difficulty is increased in the case of metropolitan railways, in which the number of vehicles, and therefore the number of batteries to be maintained, can be up to several hundred. Not only does this involve a problem from the numeric point of view and therefore from the point of view of the time used in maintenance, but also from the point of view of the large number of different batteries used.

- Environmental conditions. Railway batteries are not located in rooms with controlled temperature, moisture and dirt conditions, but, in contrast, they are subject to the rigors of outdoor environmental conditions, which can vary greatly. Furthermore, this thermal variation can be in the short-term as the train travels along its path or in the long-term, due to the passage of the seasons (summer - winter).

- Deep discharges. One of the main functions of any battery is to assure the electric supply when the main power source is switched off. In stationary battery systems the main power source is usually the conventional electrical grid, whereas in the case of the railways, electronic power equipment converts the main supply voltage into other voltages which can be used by the different equipment of the vehicle. The reliability of these power systems is less than that of the electrical grid if they are measured by average time between malfunctions. This difference is furthermore accentuated if only those service interruptions lasting more than 30 minutes are considered. The direct consequence of this particularity is that the number of deep discharges of a railway battery is much greater than that of a battery located in a stationary environment, which affects the life expectancy of said battery and therefore must be taken into account in the maintenance plan.

These conditioning factors make it necessary to design maintenance plans which minimize the demanding tasks to be performed and the time used, while at the same time assuring the lifetime of the batteries until the following expected maintenance cycle, or at least providing information which allows estimating the remaining service life before malfunction in order to take a proactive stance and thus be able to act before the damage occurs.

As previously stated, battery maintenance techniques used today for the railway environment are similar to those used in stationary environments, such as the measurement of the internal impedance, which is based on measuring the impedance of each individual cell of each battery in order to thus diagnose the state according to the dispersion of the impedance values of different cells within the same battery. In other words, the diagnosis is based or grounded on a comparison of all the impedance values of each cell with the mean. An example of this can be seen on JP-A-2006292565.

This methodology, however, has a series of significant limitations and deficiencies when it is applied to batteries in the railway environment, such as the following:

- A great deal of time is required for the operations because it is necessary to individually measure all the cells of the battery, one by one. In batteries that are typically used for railway applications, which have a large number of cells (a 110V battery has 52 Pb cells or 80 Ni-Cd cells) a great deal of time is required for the complete measurement. If this great deal of time for each battery is multiplied by the number of batteries to be maintained, it results in an excessive hourly cost for maintenance tasks.
- The location of the batteries in the railway environment is often difficult to access, hindering the measurement of the impedance, which must be taken in terminals of each cell. This directly affects safety, because taking measurements makes it necessary to expose the protections of said terminals, with the risk of accidental short circuits that this involves due to metal objects falling on the battery, or even more serious, involuntary operator contact.
- Inability to establish trends. Techniques based on the impedance measurement diagnose the state of the battery by comparing the impedance of each cell with the mean of the measured group. Since it is a relative measurement, a cell can be useful if it is measured in the group of a battery, but useless or defective if another different battery is installed. This relativity prevents associating a good or poor state with each cell individually, so it is impossible to establish a trend for the deterioration of each cell over time.

Description of the Invention

The method for the predictive maintenance of batteries of the invention which is described below solves the aforementioned drawbacks as it provides a safe and reliable system for diagnosing the state of batteries in dynamic environments, such as the railway environment, in which aspects which significantly vary the impedance, such as both the effect of the temperature and the ageing of said batteries, are taken into account.

Generally, the method of the invention is mainly based on an absolute measurement of the impedance at the module level, i.e., on a measurement of the groups of individual cells, which involves obvious improvements with respect to current cell measurement systems, since the reduction of time used in said measurement is obvious since fewer measurements are required, especially in those cases in which said cells are located in more inaccessible places. This reduction in time will furthermore be aided by the fact that it is not necessary to remove the protections from the terminals.

The non-necessity to remove the protection from the terminals is due to the fact that since the modules are connected in series, the terminals of these interconnections between modules are usually accessible. This means that in addition to the aforementioned time savings, accidental risky contacts are prevented, thereby improving operator safety. Likewise, not having to access the cells located in the more inaccessible places results in an improvement in the ergonomics of the measuring work, preventing injuries due to unsuitable postures or overstraining.

Finally, given that the method of the invention is based on the measurement of absolute impedance values at the module level instead of doing it by comparing cell values with that of the entire battery, the obtained value is thus independent from that of the other modules, which opens a door to conducting trend studies and thus being able to implement a predictive maintenance plan.

As previously stated, in order for the effect of the temperature and of the time the battery has been operating to be taken into account in the measurement taken in each module, respective correction algorithms for correcting said measurement are applied, which algorithms are previously calculated based on a sufficiently representative sample of batteries of the same model.

More specifically, a first correction algorithm for correcting impedance with the temperature is calculated, followed by a second algorithm, referred to as a contrast algorithm, applied to said corrected impedance for the purpose of taking into account the effect that ageing of the batteries has on the impedance.

Obtaining the correction algorithm for correcting impedance with the temperature is based on the fact that, regardless of the type of battery, the internal impedance decreases as the temperature increases, said variation being virtually linear.

Obtaining this algorithm comprises the following steps:

- Measuring the impedance of several modules of batteries of the same model in different life cycle states, specifically in the initial state, at the end of their service life and in one or several intermediate states.
- Taking measurements of the impedance of each module at different temperatures.
- Obtaining, for each of the modules, the family of straight lines of impedance as a function of temperature as follows:

$$Z = m_i \cdot T + a_i \qquad (a)$$

- Obtaining, for each module and temperature at which the measurements have been taken, pairs of values which define a set of straight lines relating the impedance Z and the slope $m_i$ for each T value$_j$ as follows:

$$Z = b_j \cdot m + k \qquad (b)$$

- Obtaining the value of $b_j$, which varies considerably with each value of j, in contrast with k, the value of which is very similar for each value of j, because in ideal conditions (m=0) the impedance is not modified for the temperature, therefore for any T the value of Z is the same, k. Said obtaining the value of $b_j$, as a function of T, consists of taking the set of values $b_j$ produced by each $T_j$ as a linear variation of the type:

$$b_j = \alpha \cdot T + \beta \qquad (c)$$

wherein $b_j$ is the slope of the straight lines (m,Z) obtained for each temperature value.

Then, for each fixed T value, the value of b is determined and the straight line joining these points is calculated, the $\alpha$ and $\beta$ values being obtained.

- Obtaining the expression of the compensation to be applied by combining the expressions (b) and (c), as follows:

$$m(m\Omega / {}^{o}C) = \frac{Z - k}{\alpha T + \beta} \qquad (d)$$

As previously stated, given that impedance decreases with temperature, the value of m is negative, a fact that is used in obtaining the second correction algorithm, the contrast algorithm for said impedance as a function of the state of the point of the life cycle the battery is in.

Once this expression is found, any impedance measurement taken by the operator in the modules at a given temperature is in the condition to be referenced, the corrected impedance Z* thus being obtained with the temperature, and it is none other than the value that would have been measured in a battery if it were at a reference temperature $T_0$ instead of the actual temperature T it was at when the measurement was taken.

In other words, the correction algorithm for correcting impedance with temperature relates the impedance measurements taken by the operator in each module at different temperatures, where appropriate, with the theoretical impedance value that would have been measured if at the time the temperature was equal to the reference temperature $T_0$.

Said reference temperature can be any temperature, provided it is the same over the entire lifetime of the method for diagnosing, which value can be fixed a *priori*, for example, by the person applying the method of the invention.

Therefore, for finally obtaining the value of the corrected impedance Z* the following steps must be added to the previous steps:

- Fixing an arbitrary temperature.
- Taking samples of or measuring the impedance of a module.
- Measuring the temperature T in the terminals of the module in which the impedance was just measured.
- Entering the experimentally measured values of Z and T in the expression (d) to obtain the correction in (m$\Omega$/$^o$C) which must be applied and thus obtain Z*, where said Z* is determined by the expression:

$$Z^{*} = Z - m \, ( T - T_0 ) \qquad (e)$$

Therefore, finding the value of m and substituting in (d), the following is obtained:

$$Z^{*} = Z - \frac{Z - k}{\alpha T + \beta}(T - T_0) \qquad (f)$$

Then, once the corrected impedance values are calculated through the correction algorithm for correcting impedance with the temperature described above, a second algorithm, referred to as a contrast algorithm, as previously stated, is applied thereon to the corrected impedance for the purpose of taking into account the effect that the ageing of the batteries has on impedance.

This contrast algorithm is based on statistical methods, i.e., it is a statistical algorithm which assures that the probability of considering a good battery to be poor is always bounded from above, or in other words, an algorithm by means of which the percentage of good batteries which are going to be considered poor batteries can be defined beforehand in order for the probability of considering a poor battery a good battery to be negligible. Said probability can therefore be fixed beforehand according to the specific requirements of each maintenance job for the purpose of fixing "pass- no pass" or "suitable - unsuitable" values of the diagnosis criterion.

Obtaining this contrast algorithm comprises the following steps:

- Measuring the impedance of a representative amount of modules in service of the same type and model, applying the correction algorithm for correcting impedance according to the temperature of the previous steps.

To make the work easier, it is appropriate to transform the corrected impedance $Z*$ into a new variable X which follows a normal distribution, according to any known statistical transformation method.

- Obtaining the normal distribution of the transformed variable X.
- Maximum likelihood estimators of the distribution of the variable X are calculated for the purpose of having the distribution of values for usable battery modules of the studied model perfectly characterized.
- Then, the upper limit of the confidence interval is fixed for the variable X from the maximum likelihood estimators, which will give the upper limit from which the module is not considered suitable.
- Subsequently, the limits of the confidence interval for the variable X are transformed into variable $Z*$ by means of the corresponding inverse transform.
- Finally, the diagnosis of "usable - non-usable" of the module is done by comparing the corrected impedance values $Z*$ previously obtained with the aforementioned upper limit of the confidence interval such that if the measured value is greater than the limit value, the battery will have used up its service life and the risk of malfunction is high, and therefore it is necessary to replace it.

Description of the Drawings

To complement the description being made and for the purpose of aiding to better understand the features of the invention according to a preferred practical embodiment thereof, a set of drawings is attached to said description as an integral part thereof in which the following is depicted with an illustrative and nonlimiting character:

Figure 1 shows a graph of the relationship between impedance Z and temperature T for an embodiment of the present invention.
Figure 2 shows a graph of the family of straight lines which is obtained from the relationship between impedance Z and temperature T of the previous graph.
Figure 3 shows a graph of the family of straight lines which is obtained from relating impedance Z and slope m of the straight lines of the previous figure for each T value.
Figure 4 shows a graph of the straight line representing the value of the slope of the straight lines (m, Z) of the previous graphs obtained for each T value.
Figure 5 shows a graph relating the discharge voltage and the no-load voltage during certain time intervals.
Figure 6 finally shows a flow chart describing the stages of the method of the invention for a specific embodiment.

Preferred Embodiment of the Invention

According to a possible practical embodiment of the method for diagnosing batteries of the invention, the first stage, prior to taking measurements of impedances of the modules of the batteries object of study, would be to calculate the correction algorithm for correcting impedance with the temperature, according to the following stages:

- First, the impedance of, for example, 4 modules, a new module, a module at the end of its service life and two damaged modules, is measured. Said modules are chosen in the damaged state because the magnitude of the correction depends on the state of the module, so the worse the state, the greater the magnitude of the correction. The limit case is when the module is damaged and cannot be recovered, its replacement being necessary. This limit case will indicate the maximum value of the correction, which is very useful information for determining said correction.

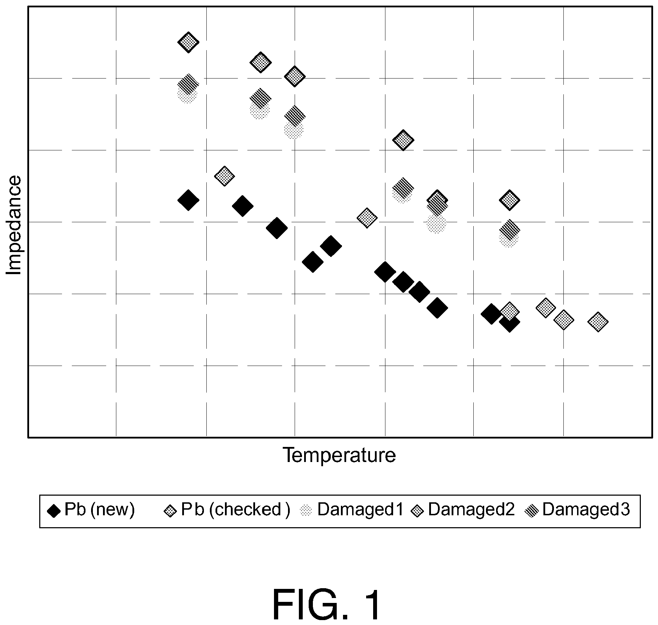

- Measurements of the impedance are taken for each module at different temperatures, for example between 5 and 35ºC in intervals of 5ºC.
- Each of the four modules is subjected to identical thermal cycles in a climatic chamber, starting with the lowest temperature, which is reached in a minimum of 18 hours, reprogramming said chamber in intervals of 5 degrees and waiting at least 6 hours to stabilize the temperature of each module and thus overcome the thermal inertia thereof, the impedance values of the module being measured in each of those intervals, which results in a graph of the impedance in relation to the temperature, such as that of Figure 1.

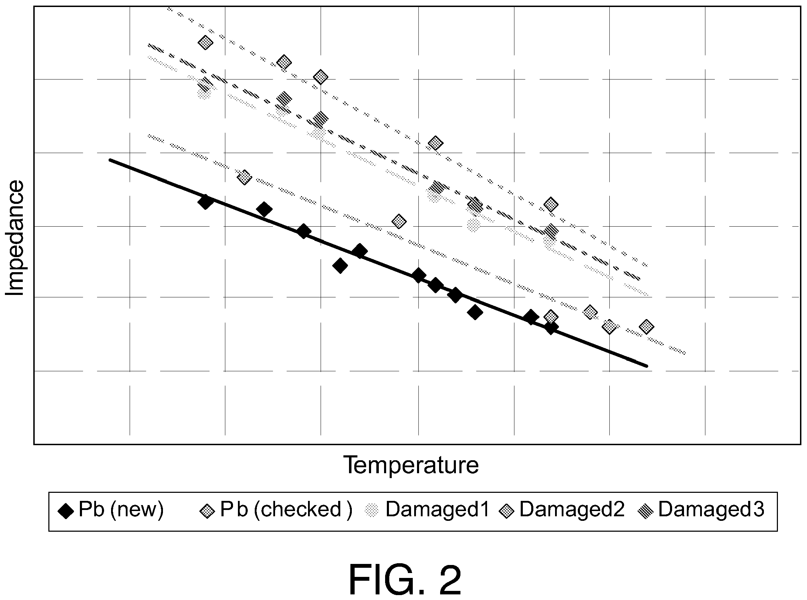

- In the following stage, as can be seen in Figure 2, the family of straight lines of impedance is obtained as a function of temperature, corresponding to the equation:

$$Z = m_i \cdot T + a_i \qquad\qquad (a)$$

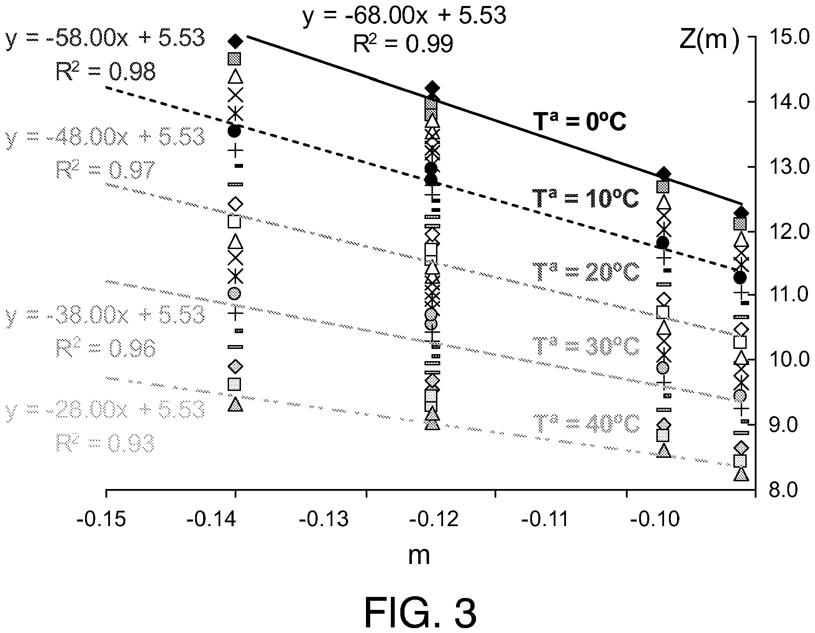

- Obtaining, for each module and temperature at which measurements have been taken, pairs of values defining a set of straight lines according to the graph depicted in Figure 3, in which the impedance Z and the slope $m_i$ are related for each $T_j$ value, corresponding to the equation:

$$Z = bj \cdot m + k \qquad\qquad (b)$$

- Obtaining the value of $b_j$ as a function of T, which consists of taking the set of values $b_j$ produced by each $T_j$ as a linear variation of the type:

$$bj = \alpha \cdot T + \beta \qquad\qquad (c)$$

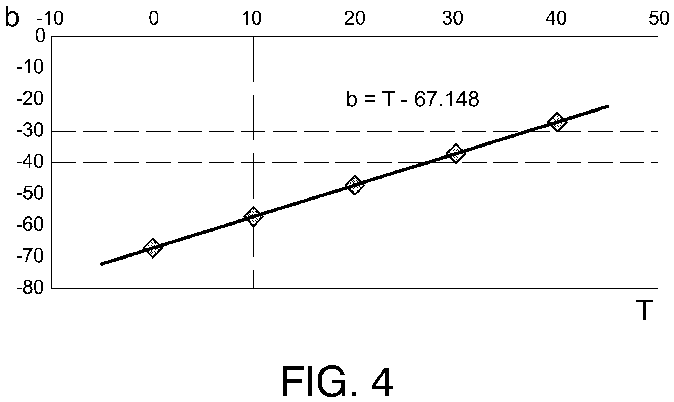

which is depicted in Figure 4 as a straight line corresponding to said equation.

- Then, the expression of the compensation to be applied would be obtained by joining the expressions (b) and (c) as follows:

$$m(m\Omega /^{\circ} C) = \frac{Z - k}{\alpha T + \beta} \qquad\qquad (d)$$

and which for the value of k of the embodiment, which is conceptually the impedance that a module would have to have in order for it to be insensitive to temperature variations, produces the value of 5.53, common to all the straight lines that are observed in Figure 3, so the following is obtained:

$$Z = (b_j\, m) + 5.53$$

and from the stage depicted by the graph of Figure 4:

$$b = T - 67.15$$

where the value of 67.15 has been obtained by calculating the $\alpha$ and $\beta$ values for the line of regression of expression (c), which for this specific case are $\alpha = 1$ and $\beta = -67.15$

substituting in (d), the following is obtained:

$$m\ (m\Omega / ^{\circ}C) = (Z - 5.53) / (T - 67.15)$$

Therefore, once this expression is found, the impedance measurements taken by the operator in the modules at a given temperature are in the condition to be referenced, the corrected impedance Z* being obtained with the temperature for each value.

Said temperature could be, for example, 20ºC, so in order to obtain the result of the corrected impedance Z* it is enough to substitute the measured values of Z and T and said reference temperature in the expression (f):

$$Z^* = Z - \frac{Z-k}{\alpha T + \beta}(T - T_0) \qquad\qquad (f)$$

Then, the second algorithm, referred to as a contrast algorithm, is applied to said corrected impedance for the purpose of taking into account the effect that the ageing of the batteries has on impedance, and consisting of the following steps for an example of the method of the invention:

- Measuring the impedance of preferably more than 80 modules to assure a precise enough distribution, i.e., the most representative of reality as possible, and for the present example it is measured on about 496 new modules and 424 modules already in service .

It is necessary to obtain the distribution for new modules and usable modules, since impedance tends to increase over time. Therefore, while the distribution of new modules corresponds rather well to a normal distribution because all the measured modules have the same time of use, i.e., zero or none, when dealing with the distribution of usable modules the service time of each module is heterogeneous, there being able to be modules with a long service time and hence with high impedance values. This generates a skew in the distribution, with a tail extending towards higher values.

- By discarding atypical data, i.e., that data outside the interval [μ - 2.5·s, μ + 2.5·s] according to the Chebyshev bound, which is used to know the percentage of data in the range [μ-kσ, μ+kσ], where μ is the sample mean and s the standard deviation of the sample, the following is obtained:

$$P(\%) \leq 100 * \frac{1}{k^2} = 100 * \frac{1}{2.5^2} = 16\%$$

As explained above in the description of the invention, in order to make the work easier, the corrected impedance Z* was transformed into a new variable X which followed a normal distribution, for which purpose the embodiment of the invention uses the so-called Box-Cox transformation, which consists of defining said variable X as:

$$X = \frac{(Z^*)^\lambda - 1}{\lambda}$$

by subsequently calculating for the usable modules the maximum likelihood estimator of said parameter λ, i.e., that value of λ which makes the support function L(λ) maximum.
The support function L(λ) (or likelihood logarithm) according to the parameter λ being:

$$L(\lambda) = -\frac{n}{2}\ln\sum(y_i(\lambda) - \overline{y}(\lambda))^2$$

wherein:

$$y_i(\lambda) = \frac{Z^\lambda - 1}{\lambda\Omega^{\lambda-1}}$$

where Z is the corrected impedance and Ω is the geometric mean of all the measurements of Z, and $\overline{y}(\lambda)$ the average of all the $y_i$
Therefore, for the present practical embodiment a value of λ = -2.615 is obtained, with which the variable X is distributed as a normal with a mean of 0.3815 and a standard deviation of 0.00028.
Then, a confidence interval is fixed for X with a significance level of 0.90, which means that the probability that a value greater than the upper limit actually belongs to the distribution of usable modules is 10% (1 - 0.90 = 0.10).

Even though said value is arbitrarily fixed, it must be high enough so as to not discard too many usable modules, but not too high because then a module with a depleted service life could "slip past" as good. The value chosen for the example is perfectly assumable from the point of view of unnecessary disassemblies and it furthermore reduces the possibility of considering a usable module to be good to very low values.

Therefore, for the example considered said confidence value produces a critical value of 0.38186 for the variable X. By then applying the corresponding inverse transform:

$$Z^* = \left(1 + \lambda x\right)^{\frac{1}{\lambda}} \quad ;$$

for this specific case the following critical value is obtained for $Z^*$:

$$Z^* = \left(1 + \lambda x\right)^{\frac{1}{\lambda}} = (1 - 2.615 \cdot 0{,}38186)^{\frac{1}{-2.615}} = 12.24$$

such that if the measured value is greater than the limit value ($Z^*$=12.24), the service life of the battery will have depleted and the risk of malfunction is high and therefore the battery must be replaced.

Finally, there is a case in which the previously described method is unable to detect the malfunction in the battery, which is when an internal short circuit occurs between some of the plates forming part of each cell of the module.

This presents a problem since, although the impedance typically increases as the state of the battery deteriorates, in these cases the exact opposite occurs, i.e., the impedance decreases.

However, this reduction of the impedance is coupled with a reduction of the voltage of the cell involved, which can reach virtually nil values depending on the severity of the short circuit.

This reduction of voltage, nevertheless, can be discriminated and therefore detected according to the following: For lead batteries, the manufacturer gives a voltage limit of 1.7 V/cell corresponding to the maximum possible discharge without irreversible consequences for the life of the battery. In a module with 6 cells, this voltage equals: 1.7 x 6 = 10.2 V, which voltage must be measured while the battery is being discharged, i.e., while it is delivering current during its operation.

In the railway field, the voltage of each module can only be measured once it is taken to the repair shop, i.e., the battery has no load (no current is delivered).

It has been experimentally found that if a battery is being discharged and the discharge is interrupted, the voltage starts to recover even though the battery is not being recharged, i.e., the voltage given by the manufacturer is not valid when the battery is measured when it has no load.

It is therefore necessary to find a relationship between the voltage measurement with the battery being discharged and the measurement with the battery when it has no load.

To that end, a charged module is discharged through a resistor at a discharge current of approximately 1.35 $C_5$ (where $C_5$ is standard nomenclature, meaning what current value is necessary for discharging a fully charged battery in 5 hours. For example, for a 120 Ah battery, $C_5$ would be 24 A)

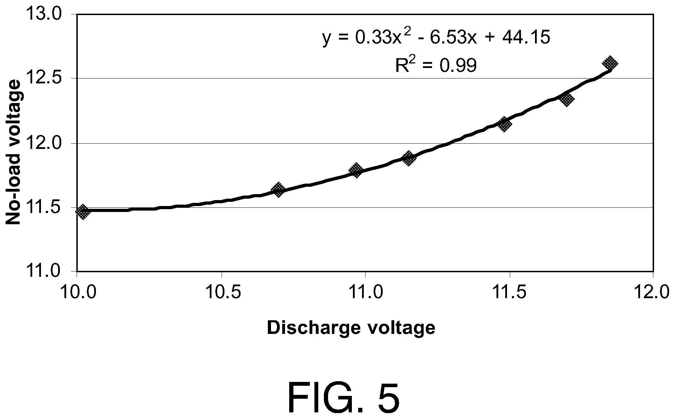

Then the voltage is measured during the discharge and the discharge is stopped every certain time interval, the battery is left to rest 5 minutes and a voltage measurement is taken (now with the battery without a load). After this measurement, the discharge recommences, all according to what can be seen in Figure 5, where a good fit by means of a second degree curve can be seen.

In said graph, the last point taken (at 10.02 V during the discharge) is at the limit of what the battery can deliver, stopping the test at this point since it is then that the voltage began to drop abruptly, an unequivocal sign of battery depletion.

In other words, the theoretical maximum discharge limit given by the manufacturer coincides with the experiment conducted, and even more importantly, the value of this voltage limit if the measurement had been taken without a load is determined.

Therefore, this test determines that even though a usable battery is discharged, it will always have voltage values greater than 11.5 V when it is measured with no load, said value of 11.5 v being obtained upon entering the theoretical value 10.2 given by the manufacturer in the expression of the regression curve shown in the graph in said Figure 5.

The type of malfunction described above (internal short circuit of some plates) virtually cancels the voltage of a cell, so the no-load voltage of a module with this problem but the 5 cells of which are in a good state would be: The sum of the no-load voltage (2.1 V for lead batteries) of the five cells that are in a good state => 5 x 2.1 = 10.5 V, plus the residual voltage that may remain in the cell involved (in any case less than 1 V), so the voltage of a module experiencing this type of malfunction will always be < 11.5 V, no matter how good the state of the five unaffected cells.

A diagnosis criterion that can be applied to the method of the invention and allows determining if this type of malfunction has occurred has thus been obtained, specifically for the practical case of the example, if the no-load voltage of the module is less than 11.5 volts, the module does not serve for being used.

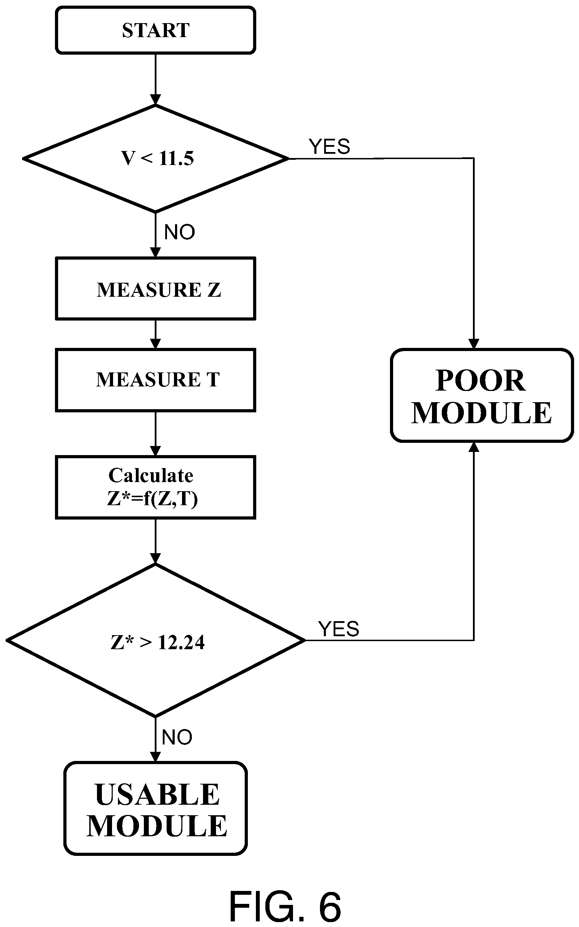

Finally, Figure 6 shows a schematic flow chart of the entire method for diagnosing of the invention in which the eventuality described above, i.e., a malfunction took place due to a short circuit, has also been taken into account.

**Claims**

1.  Method for diagnosing batteries, **characterized in that** it comprises the stages of:

    - measuring the voltage of a module comprising a group of individual cells to check if an internal short circuit has occurred between any of the plates forming part of each cell of the module so that said module can be discarded as it is defective;
    - in case the module is not defective, measuring the impedance of the module;
    - correcting the value of the impedance of the module by means of applying a correction algorithm for correcting said impedance with the temperature; and
    - applying a second algorithm to the impedance corrected by means of the previous stage such that the effect that the ageing of the batteries has on said corrected impedance is taken into account; and

    comparing the value of the corrected impedance taking into account the temperature and the ageing of the battery previously obtained in the previous stages with an upper limit and performing the diagnosis of "usable - non-usable" according to whether or not said value of the impedance is greater than the mentioned upper limit.

2.  Method for diagnosing batteries according to claim 1, **characterized in that** the correction algorithm for correcting impedance with the temperature comprises the stages of:

    - measuring the impedance of several modules of batteries of the same model in different life cycle states;
    - measuring the impedance of each module at different temperatures;
    - obtaining, for each of the modules, the family of straight lines of impedance as a function of temperature, according to:

$$Z = m_i \cdot T + a_i \qquad (a) ;$$

    where
    Z= impedance; T= temperature; $m_i$ = slope for each T value$_j$
    - obtaining the set of straight lines relating impedance Z and slope $m_i$ for each $T_j$ value, according to:

$$Z = b_j \cdot m + k \qquad (b) ;$$

    where
    $b_j$= is the slope of the straight lines (m,Z) obtained for each temperature value
    - obtaining the value of $b_j$, consisting of taking the set of values $b_j$ produced by each $T_j$ as a linear variation according to:

$$b_j = \alpha \cdot T + \beta \qquad (c) ;$$

    - determining, for each fixed T value, the value of b and obtaining the $\alpha$ and $\beta$ values; and
    - obtaining the expression of the compensation to be applied by joining the expressions (b) and (c), according to:

$$m(m\Omega /^{\circ}C) = \frac{Z - k}{\alpha T + \beta} \qquad (d)$$

3. Method for diagnosing batteries according to claim 2, **characterized in that** the different life cycle states in which the impedance is measured comprise the initial state, the end of their service life and one or several intermediate states.

4. Method for diagnosing batteries according to the previous claims, **characterized in that** obtaining the corrected impedance comprises the steps of:

- fixing an arbitrary temperature;
- taking samples of or measuring the impedance of a module;
- measuring the temperature T in the terminals of the module in which the impedance Z was just measured;
- applying the correction algorithm for correcting impedance with the temperature to the experimentally measured values of Z and T to obtain the correction Z* in (mΩ/°C) according to:

$$Z^* = Z - m\,(\,T - T_0)\qquad (e)\;;$$

where $T_0$= reference Temperature
- obtaining by substituting in (d):

$$Z^* = Z - \frac{Z-k}{\alpha T + \beta}(T-T_0)\qquad (f);$$

where Z*= corrected impedance

5. Method for diagnosing batteries according to the previous claims, **characterized in that** the second algorithm applied to the corrected impedance comprises the stages of:

- measuring the impedance of a representative amount of modules in service of the same type and model, applying the correction algorithm for correcting impedance;
- transforming the corrected impedance Z* into a variable X which follows a normal distribution;
- obtaining the normal distribution of the transformed variable X;
- calculating the maximum likelihood estimators of the distribution of the variable X;
- fixing the upper limit of the confidence interval for the variable X from the maximum likelihood estimators,
- transforming the limits of the confidence interval for the variable X into the variable Z* by means of the corresponding inverse transform; and
- comparing the corrected impedance values Z* previously obtained with the upper limit of the confidence interval and performing the diagnosis of "usable - non-usable" according to whether or not said measured value is greater than the mentioned upper limit.

6. Method for diagnosing batteries according to claim 5, **characterized in that** the statistical transformation method for transforming the corrected impedance Z* into a variable X which follows a normal distribution is the Box-Cox transformation.

7. Method for diagnosing batteries according to claim 1, **characterized in that** checking if an internal short circuit has occurred between any of the plates forming part of each cell of the module comprises calculating the relationship between the measured voltage with the battery being discharged and the measurement with the battery when it has no load such that if the voltage measurement in the module of the battery when it has no load is less than a calculated value said module can be discarded as it is defective.

**Patentansprüche**

1. Verfahren zum Diagnostizieren von Batterien, **dadurch gekennzeichnet, dass** dasselbe folgende Stufen aufweist:

Messen der Spannung eines Moduls, das eine Gruppe individueller Zellen aufweist, um zu prüfen, ob ein innerer Kurzschluss zwischen beliebigen der Platten aufgetreten ist, die einen Teil jeder Zelle des Moduls bilden, so dass das Modul ausgesondert werden kann, da es defekt ist;

falls das Modul nicht defekt ist, Messen der Impedanz des Moduls;

Korrigieren des Impedanzwerts des Moduls mittels Anlegen eines Korrekturalgorhitmus zum Korrigieren der Impedanz mit der Temperatur und

Anlegen eines zweiten Algorithmus an die Impedanz, die mittels der vorhergehenden Stufe korrigiert wird, derart, dass die Auswirkung, die das Altern der Batterien auf die korrigierte Impedanz hat, berücksichtigt wird; und Vergleichen des Werts der korrigierten Impedanz unter Berücksichtigung der Temperatur und des Alterns der Batterie, die zuvor bei den vorherigen Stufen erhalten werden, mit einer Obergrenze und Durchführen der Diagnose "verwendbar - nicht verwendbar" je nachdem, ob der Wert der Impedanz größer als die erwähnte Obergrenze ist oder nicht.

2. Verfahren zum Diagnostizieren von Batterien gemäß Anspruch 1, **dadurch gekennzeichnet, dass** der Korrekturalgorithmus zum Korrigieren der Impedanz mit der Temperatur folgende Stufen aufweist:

Messen der Impedanz mehrerer Module von Batterien desselben Modells in unterschiedlichen Lebenszykluszuständen;

Messen der Impedanz jedes Moduls bei unterschiedlichen Temperaturen;

Erhalten der Familie von Impedanzgeraden für jedes der Module in Abhängigkeit von der Temperatur gemäß:

$$Z = m_i \cdot T + a_i \qquad \text{(a);}$$

wobei

Z = Impedanz; T = Temperatur; $m_i$ = Steigung für jeden $T$-Wert$_j$

Erhalten des Satzes von Geraden, die die Impedanz Z und die Steigung $m_i$ für jeden $T_j$-Wert in Beziehung bringen, gemäß:

$$Z = b_j \cdot m + k \qquad \text{(b);}$$

wobei

$b_j$ = die Steigung der Geraden (m,Z) ist, die für jeden Temperaturwert erhalten wird

Erhalten des Werts $b_j$, umfassend ein Verwenden des Satzes von Werten $b_j$, die durch jeden $T_j$ erzeugt werden, als eine lineare Variation gemäß:

$$b_j = \alpha \cdot T + \beta \qquad \text{(c);}$$

Bestimmen, für jeden festen T-Wert, des Werts b und Erhalten der $\alpha$- und $\beta$-Werte und

Erhalten des Ausdrucks der anzulegenden Kompensation durch Verbinden der Ausdrücke (b) und (c) gemäß:

$$m(m\Omega/^\circ C) = \frac{Z - k}{\alpha T + \beta} \qquad \text{(d)}$$

3. Verfahren zum Diagnostizieren von Batterien gemäß Anspruch 2, **dadurch gekennzeichnet, dass** die unterschiedlichen Lebenszykluszustände, in denen die Impedanz gemessen wird, den Anfangszustand, das Ende der Nutzungsdauer derselben und einen oder mehrere Zwischenzustände aufweisen.

4. Verfahren zum Diagnostizieren von Batterien gemäß den vorhergehenden Ansprüchen, **dadurch gekennzeichnet, dass** ein Erhalten der korrigierten Impedanz folgende Schritte aufweist:

Fixieren einer willkürlichen Temperatur;

Entnehmen von Proben oder Messen der Impedanz eines Moduls;

Messen der Temperatur T in den Anschlüssen des Moduls, in dem die Impedanz Z soeben gemessen wurde;

Anlegen des Korrekturalgorithmus zum Korrigieren der Impedanz mit der Temperatur an die experimentell gemessenen Werte und T, um die Korrektur Z* in (mΩ/°C) zu erfassen, gemäß:

$$Z^* = Z - m \, ( \, T - T_0 \, ) \qquad (e);$$

wobei $T_0$ = Referenztemperatur

Erhalten durch Substituieren in (d):

$$Z^* = Z - \frac{Z-k}{\alpha T + \beta}(T - T_0) \qquad (f);$$

wobei Z*= korrigierte Impedanz

5. Verfahren zum Diagnostizieren von Batterien gemäß den vorhergehenden Ansprüchen, **dadurch gekennzeichnet, dass** der zweite Algorithmus, der an die korrigierte Impedanz angelegt ist, folgende Stufen aufweist:

Messen der Impedanz einer repräsentativen Menge von in Betrieb befindlichen Modulen desselben Typs und Modells, Anlegen des Korrekturalgorithmus zum Korrigieren der Impedanz;
Transformieren der korrigierten Impedanz Z* in eine Variable X, die einer Normalverteilung folgt;
Erhalten der Normalverteilung der transformierten Variable X;
Berechnen der Maximum-Likelihood-Schätzer der Verteilung der Variablen X;
Fixieren der Obergrenze des Vertrauensintervalls für die Variable X von den Maximum-Likelihood-Schätzern, Transformieren der Grenzen des Vertrauensintervalls für die Variable X in die Variable Z* mittels der entsprechenden inversen Transformation und
Vergleichen der korrigierten Impedanzwerte Z*, die zuvor mit der Obergrenze des Vertrauensintervalls erhalten wurden, und Durchführen der Diagnose "verwendbar - nicht verwendbar" je nachdem, ob der gemessene Wert größer als die erwähnte Obergrenze ist oder nicht.

6. Verfahren zum Diagnostizieren von Batterien gemäß Anspruch 5, **dadurch gekennzeichnet, dass** das statistische Transformationsverfahren zum Transformieren der korrigierten Impedanz Z* in eine Variable X, die einer Normalverteilung folgt, die Box-Cox-Transformation ist.

7. Verfahren zum Diagnostizieren von Batterien gemäß Anspruch 1, **dadurch gekennzeichnet, dass** ein Prüfen, ob ein innerer Kurzschluss zwischen beliebigen der Platten aufgetreten ist, die einen Teil jeder Zelle des Moduls bilden, Folgendes aufweist: Berechnen der Beziehung zwischen der gemessenen Spannung bei entladener Batterie und der Messung mit der Batterie, wenn dieselbe keine Last aufweist, derart dass, falls die Spannungsmessung in dem Modul der Batterie, wenn dieselbe keine Last aufweist, kleiner als ein berechneter Wert ist, das Modul ausgesondert werden kann, da es defekt ist.

**Revendications**

1. Procédé de diagnostic de batteries, **caractérisé en ce qu'**il comprend les étapes de :

- mesure de la tension d'un module comprenant un groupe de cellules individuelles pour vérifier si un court-circuit interne s'est produit entre l'une quelconque des plaques faisant partie de chaque cellule du module, de sorte que ledit module puisse être écarté parce qu'il est défectueux ;
- dans le cas où le module n'est pas défectueux, mesure de l'impédance du module ;
- correction de la valeur de l'impédance du module au moyen de l'application d'un algorithme de correction pour corriger ladite impédance avec la température ; et
- application d'un deuxième algorithme à l'impédance corrigée au moyen de l'étape précédente de sorte que l'effet du vieillissement des batteries sur ladite impédance corrigée soit pris en compte ; et

comparaison de la valeur de l'impédance corrigée tenant en compte de la température et du vieillissement de la batterie précédemment obtenue aux étapes précédentes à une limite supérieure et réalisation du diagnostic de "utilisable - non utilisable" selon que ladite valeur de l'impédance est supérieure ou non à la limite supérieure mentionnée.

2. Procédé de diagnostic de batteries selon la revendication 1, **caractérisé en ce que** l'algorithme de correction pour corriger l'impédance en fonction de la température comprend les étapes de :

- mesure de l'impédance de plusieurs modules de batteries du même modèle dans différents états de cycle de vie ;
- mesure de l'impédance de chaque module à différentes températures ;
- obtention, pour chacun des modules, de la famille de lignes droites d'impédance en fonction de la température, selon :

$$Z = m_i \cdot T + a_i \qquad (a) \ ;$$

où

Z = impédance ; T = température ; $m_i$ = pente pour chaque valeur$_j$ T ;
- obtention de l'ensemble de lignes droites reliant l'impédance Z et la pente $m_i$ pour chaque valeur $T_j$, selon :

$$Z = b_j \cdot m + k \qquad (b) \ ;$$

où $b_j$ = est la pente des lignes droites (m, Z) obtenues pour chaque valeur de température
- obtention de la valeur de $b_j$ consistant à prendre l'ensemble de valeurs $b_j$ produites par chaque $T_j$ comme une variation linéaire selon :

$$b_j = \alpha \cdot T + \beta \qquad (c) \ ;$$

- détermination, pour chaque valeur T fixée, de la valeur de b et obtention des valeurs de $\alpha$ et $\beta$ ; et
- obtention de l'expression de la compensation à appliquer par union des expressions (b) et (c), selon :

$$m(m\Omega/°C) = \frac{Z - k}{\alpha T + \beta} \qquad (d)$$

**3.** Procédé de diagnostic de batteries selon la revendication 2, **caractérisé en ce que** les différents états de cycle de vie dans lesquels l'impédance est mesurée comprennent l'état initial, la fin de leur durée de vie et un ou plusieurs états intermédiaires.

**4.** Procédé de diagnostic de batteries selon les revendications précédentes, **caractérisé en ce que** l'obtention de l'impédance corrigée comprend les étapes de :

- fixation d'une température arbitraire ;
- prélèvement d'échantillons ou mesure de l'impédance d'un module ;
- mesure de la température T aux bornes du module dans lequel l'impédance Z vient d'être mesurée ;
- application de l'algorithme de correction pour corriger l'impédance avec la température aux valeurs expérimentalement mesurées de Z et T pour obtenir la correction Z* dans (m$\Omega$/°C) selon :

$$Z^* = Z - m (T - T_0) \qquad (e) \ ;$$

où $T_0$ = température de référence
- obtention par substitution dans (d) :

$$Z^* = Z - \frac{Z - k}{\alpha T + \beta}(T - T_0) \qquad (f) \ ;$$

où Z* = impédance corrigée.

**5.** Procédé de diagnostic de batteries selon les revendications précédentes, **caractérisé en ce que** le deuxième algorithme appliqué à l'impédance corrigée comprend les étapes de :

- mesure de l'impédance d'une quantité représentative de modules en service de mêmes type et modèle, application de l'algorithme de correction pour corriger l'impédance ;
- transformation de l'impédance corrigée Z* en une variable X qui suit une distribution normale ;
- obtention de la distribution normale de la variable transformée X ;
- calcul des estimateurs du maximum de vraisemblance de la distribution de la variable X ;
- fixation de la limite supérieure de l'intervalle de confiance pour la variable X à partir des estimateurs du maximum de vraisemblance,
- transformation des limites de l'intervalle de confiance pour la variable X en variable Z* au moyen de la transformée inverse correspondante ; et
- comparaison des valeurs d'impédance corrigée Z* précédemment obtenues à la limite supérieure de l'intervalle de confiance et réalisation du diagnostic de "utilisable - non utilisable" selon que ladite valeur de l'impédance est supérieure ou non à la limite supérieure mentionnée.

**6.** Procédé de diagnostic de batteries selon la revendication 5, **caractérisé en ce que** le procédé de transformation statistique pour transformer l'impédance corrigée Z* en une variable X qui suit une distribution normale est la transformation de Box-Cox.

**7.** Procédé de diagnostic de batteries selon la revendication 1, **caractérisé en ce que** la vérification si un court-circuit interne s'est produit entre l'une quelconque des plaques faisant partie de chaque cellule du module comprend le calcul de la relation entre la tension mesurée avec la batterie déchargée et la mesure avec la batterie quand elle n'a pas de charge, de sorte que, si la mesure de tension dans le module de la batterie lorsqu'elle n'a pas de charge est inférieure à une valeur calculée, ledit module peut être écarté parce qu'il est défectueux.

FIG. 1

FIG. 2

FIG. 3

FIG. 4

$$y = 0.33x^2 - 6.53x + 44.15$$
$$R^2 = 0.99$$

FIG. 5

```
                    ┌──────────────────┐
                    │      START       │
                    └──────────────────┘
                              │
                              ▼
                        ╱──────────╲
                       ╱   V < 11.5  ╲──────── YES ──────────────┐
                        ╲──────────╱                            │
                              │                                 │
                             NO                                 │
                              ▼                                 │
                    ┌──────────────────┐                        │
                    │    MEASURE Z     │                        │
                    └──────────────────┘                        │
                              │                                 ▼
                              ▼                      ┌────────────────────┐
                    ┌──────────────────┐             │       POOR         │
                    │    MEASURE T     │             │      MODULE        │
                    └──────────────────┘             └────────────────────┘
                              │                                 ▲
                              ▼                                 │
                    ┌──────────────────┐                        │
                    │    Calculate     │                        │
                    │    Z*=f(Z,T)     │                        │
                    └──────────────────┘                        │
                              │                                 │
                              ▼                                 │
                        ╱──────────╲                            │
                       ╱  Z* > 12.24 ╲─────── YES ──────────────┘
                        ╲──────────╱
                              │
                             NO
                              ▼
                    ┌──────────────────┐
                    │      USABLE      │
                    │      MODULE      │
                    └──────────────────┘
```

FIG. 6

**EP 2 295 997 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006292565 A